(19) Europäisches Patentamt
European Patent Office
Office européen des brevets

(11) **EP 2 501 836 B1**

(12) **EUROPÄISCHE PATENTSCHRIFT**

(45) Veröffentlichungstag und Bekanntmachung des Hinweises auf die Patenterteilung:
**12.10.2016 Patentblatt 2016/41**

(21) Anmeldenummer: **10782586.1**

(22) Anmeldetag: **19.11.2010**

(51) Int Cl.:
*C23C 14/34* (2006.01)      *C23C 14/52* (2006.01)
*H01J 37/34* (2006.01)

(86) Internationale Anmeldenummer:
**PCT/EP2010/067820**

(87) Internationale Veröffentlichungsnummer:
**WO 2011/061288 (26.05.2011 Gazette 2011/21)**

(54) **VORRICHTUNG UND VERFAHREN ZUM BESCHICHTEN EINES SUBSTRATES**

DEVICE AND METHOD FOR COATING A SUBSTRATE

DISPOSITIF ET PROCÉDÉ DE REVÊTEMENT D'UN SUBSTRAT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.11.2009 DE 102009054060**

(43) Veröffentlichungstag der Anmeldung:
**26.09.2012 Patentblatt 2012/39**

(73) Patentinhaber:
• **Fraunhofer-Gesellschaft zur Förderung der angewandten Forschung e.V.**
**80686 München (DE)**
• **Singulus Technologies AG**
**63796 Kahl am Main (DE)**

(72) Erfinder:
• **SCHÖPKA, Ulrich**
**91052 Erlangen (DE)**
• **ÖCHSNER, Richard**
**90449 Nürnberg (DE)**
• **PFEFFER, Markus**
**90409 Nürnberg (DE)**
• **MAAß, Wolfram**
**63589 Linsengericht (DE)**
• **LANGER, Jürgen**
**63075 Offenbach am Mai (DE)**
• **OCKER, Berthold**
**63454 Hanau (DE)**

(74) Vertreter: **Friese Goeden Patentanwälte**
**Widenmayerstraße 49**
**80538 München (DE)**

(56) Entgegenhaltungen:
• **ZHU X D ET AL: "Epitaxial growth of SrTiO3, on SrTiO3(001) using an oblique-incidence reflectance-difference technique", PHYSICAL REVIEW B (CONDENSED MATTER) APS THROUGH AIP USA, Bd. 57, Nr. 4, 15. Januar 1998 (1998-01-15), Seiten 2514-2519, XP002620560, ISSN: 0163-1829**

**Beschreibung**

Die Erfindung betrifft eine Vorrichtung zum Beschichten eines Substrates, enthaltend eine Vakuumkammer, deren Innenraum zur Aufnahme des zu beschichtenden Substrates und zumindest eines Sputtertargets vorgesehen ist, wobei das Sputtertarget dazu vorgesehen ist, bei Betrieb der Vorrichtung durch Teilchenbeschuss abgetragen zu werden, und die Vorrichtung weiterhin eine Einrichtung zur Bestimmung des Abtrages des Sputtertargets enthält.

Aus der DE 102 34 862 A1 ist eine Vorrichtung der eingangs genannten Art bekannt. Gemäß diesem bekannten Verfahren wird vorgeschlagen, das Sputtertarget als Materialquelle für die Beschichtung eines Substrates einzusetzen. Der Materialabtrag des Sputtertargets wird durch Beschuss der Oberfläche des Sputtertargets mit Ionen aus einem Plasma hervorgerufen. Um eine thermische Schädigung des Sputtertargets zu verhindern, kann vorgesehen sein, die eingebrachte thermische Energie mittels einer Wasserkühlung vom Sputtertarget abzuführen.

Der genannte Stand der Technik weist den Nachteil auf, dass nach dem Verbrauch des Sputtertargets die unterhalb des Sputtertargets angeordnete Trägerplatte oder eine das Sputtertarget tragende Positioniereinrichtung durch die aus dem Plasma auftreffenden Ionen abgetragen wird. Sofern dies vom Bedienpersonal unbemerkt bleibt, wird die auf dem Substrat abgeschiedene Schicht und/oder die die Vorrichtung umgebende Vakuumkammer durch das Material der Trägerplatte oder der Positioniereinrichtung verunreinigt. Wenn der Angriff auf die Trägerplatte oder die Positioniereinrichtung weiter fortdauert, können die im Inneren dieser Bauteile verlaufenden Kühlkanäle freigelegt werden, so dass das Kühlmittel in die Vakuumkammer eindringt und diese verunreinigt.

Dabei kann es durch den einsetzenden schnellen Druckanstieg zu Folgeschäden an den eingesetzten Vakuumpumpen oder den Stromversorgungseinrichtungen kommen.

Zur Lösung dieses Problems schlägt der Stand der Technik vor, den Verschleiß des Sputtertargets über das Produkt aus Sputterleistung und Prozessdauer abzuschätzen. Da diese Abschätzung fehlerbehaftet ist und der Abtrag des Targets örtlich inhomogen verlaufen kann, wird das Sputtertarget oftmals präventiv ausgetauscht, ehe die Verschleißgrenze erreicht ist. Dies führt zu einer schlechten Ausnutzung des vorhandenen Materials und zu unnötigen Standzeiten der Vorrichtung, da ein Wechsel des Sputtertargets die zeitaufwändige Belüftung und Öffnung der Vakuumkammer erfordert.

Ein optisches Monitoring von Beschichtungsverfahren ist aus ZHU X D ET AL: "Epitaxial growth of SrTiO3, on SrTiO3(001) using an oblique-incidence reflectance-difference technique", PHYSICAL REVIEW B (CONDENSED MATTER) APS THROUGH AIP USA, Bd 57, Nr 4, 15 Januar 1998 (1998-01-15), Seiten 2514-2519, ISSN: 0163-1829 bekannt.

Ausgehend von diesem Stand der Technik liegt der Erfindung daher die Aufgabe zugrunde, ein Verfahren und eine Vorrichtung anzugeben, welche das Material des Sputtertargets möglichst vollständig aufbrauchen kann, ohne die auf dem Substrat gebildete Beschichtung durch das Material der Positioniereinrichtung zu verunreinigen. Weiterhin besteht die Aufgabe der vorliegenden Erfindung darin, die Wartungsintervalle einer Vorrichtung zur Beschichtung eines Substrates zu verlängern.

Die Aufgabe wird erfindungsgemäß gelöst durch eine Vorrichtung zum Beschichten eines Substrates, umfassend eine Vakuumkammer, deren Innenraum zur Aufnahme des zu beschichtenden Substrates und zumindest eines Sputtertargets vorgesehen ist, welches dazu vorgesehen ist, bei Betrieb der Vorrichtung durch Teilchenbeschuss abgetragen zu werden, wobei die Vorrichtung weiterhin eine Einrichtung zur Bestimmung des Abtrages des Sputtertargets enthält, wobei in der Wandung der Vakuumkammer zumindest ein Fenster angeordnet ist und die Einrichtung zur Bestimmung des Abtrages des Sputtertargets eine Messeinrichtung zur optischen Messung des Abstandes zwischen zumindest einem vorgebbaren Punkt außerhalb der Vakuumkammer und zumindest einem vorgebbaren Punkt auf der Oberfläche des Sputtertargets aufweist und die Messeinrichtung weiterhin eine Auswerteeinrichtung enthält, mittels welcher ein Parallaxenversatz und/oder eine geometrische Verzerrung korrigierbar ist.

Weiterhin besteht die Lösung der Aufgabe in einem Verfahren zum Beschichten eines Substrates, bei welchem das Substrat und zumindest ein Sputtertarget in den Innenraum einer Vakuumkammer eingebracht wird und das Sputtertarget durch Teilchenbeschuss abgetragen und dessen Abtrag bestimmt wird, wobei durch ein in der Wandung der Vakuumkammer angeordnetes Fenster der Abstand zwischen zumindest einem vorgebbaren Punkt außerhalb der Vakuumkammer und zumindest einem vorgebbaren Punkt auf der Oberfläche des Sputtertargets optisch gemessen wird und die gemessenen Abstände einer Auswerteeinrichtung zugeführt werden, welche zumindest einen Parallaxenversatz und/oder eine optische Verzerrung korrigiert.

Erfindungsgemäß wird vorgeschlagen, in der Wandung der Vakuumkammer, welche die Vorrichtung zum Beschichten eines Substrates umgibt, ein Fenster einzusetzen. Unter einem Fenster im Sinne der vorliegenden Erfindung wird ein Bereich in der Wandung der Vakuumkammer verstanden, welcher für eine elektromagnetische Strahlung eines vorgebbaren Wellenlängenbereichs transparent ist. Beispielsweise kann das Material des Fensters Glas oder Quarz enthalten.

Zur optischen Messung des Abstandes zwischen zumindest einem vorgebbaren Punkt außerhalb der Vakuumkammer und zumindest einem vorgebbaren Punkt auf der Oberfläche des Sputtertargets wird eine elektromagnetische Strahlung einer vorgebbaren Wellenlänge und/oder eines vorgebbaren Wellenlängenbereichs durch das Fenster auf die Oberfläche des Sputtertargets gelenkt und dort reflektiert. Der zurückgeworfene Lichtstrahl kann von der vorgeschlagenen Messeinrichtung empfangen und ausgewertet werden. Beispielsweise kann der Abstand zwischen der Messeinrichtung und der Targetoberfläche mittels Lasertriangulation ermittelt werden. In anderen Ausführungsformen der Erfindung kann der Abstand durch Auswertung der Phaseninformation des zurückgeworfenen Lichtes oder durch Laufzeitmessung ermittelt werden. Zu diesem Zweck kann das von der Einrichtung zur optischen Messung des Abstandes emittierte Licht gepulst sein. Die Wellenlänge kann zwischen 3 $\mu$m und 200 nm betragen. In einigen Ausführungsformen kann die Wellenlänge zwischen 700 nm und 500 nm betragen.

Der das Sputtertarget abtragende Teilchenbeschuss kann durch positiv oder negativ geladene Ionen und/oder neutrale Atome bewirkt werden. In einigen Ausführungsformen der Erfindung kann der Teilchenbeschuss durch Elektronen oder Photonen bewirkt werden.

Mit fortlaufendem Abtrag des Sputtertargets wird der Abstand zwischen dem vorgegebenen Punkt außerhalb der Vakuumkammer und dem zumindest einem vorgegebenen Punkt auf der Oberfläche des Sputtertargets größer. Dadurch kann der Benutzer zu einem vorgebbaren Zeitpunkt die Dicke des Sputtertargets ermitteln. Sofern diese Veränderung des Abstandes größer oder gleich der bekannten Dicke des Sputtertargets ist, erhält der Benutzer der Vorrichtung zum Beschichten eines Substrates eine eindeutige Information darüber, dass das Sputtertarget vollständig aufgebraucht ist bzw. seine Verschleißgrenze erreicht hat. Auf diese Weise kann das Verfahren zum Beschichten eines Substrates unterbrochen werden, ehe das Material der Positioniereinrichtung und/oder der Trägerplatte des Sputtertargets durch den Ionenbeschuss abgetragen wird und die auf dem Substrat abgeschiedene Schicht verunreinigt. Dadurch wird auch zuverlässig verhindert, dass das Material dieser Bauteile soweit abgetragen wird, bis das im Inneren der Positioniereinrichtung in Kühlkanälen zirkulierende Kühlmittel an der vakuumseitigen Begrenzungsfläche austritt.

Sofern der zur optischen Messung des Abstandes verwendete Lichtstrahl unter einem von der Flächennormalen des Targets abweichenden Winkel auftrifft, kann sich eine Verzerrung der Messwerte bzw. ein Parallaxenfehler ergeben. In einigen Ausführungsformen der Erfindung kann vorgesehen sein, dass die Messeinrichtung eine Auswerteeinrichtung enthält oder mit einer Auswerteeinrichtung verbunden ist, mittels welcher ein Parallaxenversatz und/oder eine geometrische Verzerrung korrigierbar ist. Auf diese Weise kann die Dicke des Sputtertargets mit größerer Genauigkeit ermittelt werden. In einigen Ausführungsformen der Erfindung kann sich das Sputtertarget auf einer Kreisbahn vor der Messeinrichtung bewegen. In diesem Fall kann die Auswerteeinrichtung dazu vorgesehen sein, eine parabolische Verzerrung der von der Messeinrichtung aufgenommenen Messwerte zu korrigieren. Die Auswerteeinrichtung kann einen Mikroprozessor oder einen Mikrocontroller enthalten. In einigen Ausführungsformen kann die Auswerteeinrichtung eine Software umfassen, welche ein entsprechendes Korrekturverfahren auf die Messwerte anwendet, wenn die Software auf einem Computer ausgeführt wird.

In einigen Ausführungsformen der Erfindung kann die Vorrichtung weiterhin eine Positioniereinrichtung enthalten, mit welcher das Sputtertarget von einer Betriebsposition in eine Messposition bewegbar ist. Dabei bezeichnet die Betriebsposition eine Stellung des Sputtertargets, in welchem dieses dem zu beschichtenden Substrat gegenüberliegend angeordnet ist und durch auftreffende Ionen abgetragen wird, welche aus einem Plasma auf die Oberfläche des Sputtertargets auftreffen. Die Messposition bezeichnet demgegenüber eine Stellung, in welcher die Oberfläche des Sputtertargets durch das Fenster in der Wandung der Vakuumkammer beobachtet werden kann. In einigen Ausführungsformen kann die Messposition und die Betriebsposition die gleiche Stellung des Sputtertargets innerhalb der Vakuumkammer sein. In anderen Ausführungsformen der Erfindung kann sich die Messposition und die Betriebsposition räumlich unterscheiden. In diesem Fall kann vorgesehen sein, dass das Target beim Überführen von der Betriebsposition in die Messposition im Erfassungsbereich der Messeinrichtung bewegt wird, so dass Messwerte entlang einer durch die Bewegungsrichtung definierten Linie aufgenommen werden.

In einigen Ausführungsformen der Erfindung kann die Positioniereinrichtung einen Zylinder enthalten, an dessen Mantelfläche zumindest ein Sputtertarget angeordnet ist. Bei dieser Ausführungsform kann die Bewegung von einer Betriebsposition in eine Messposition durch eine einfache Rotation des Zylinders erfolgen. Die Rotation kann dabei durch einen im Inneren der Vakuumkammer angeordneten Elektromotor vermittelt werden oder durch einen außerhalb der Vakuumkammer angeordneten Antrieb, welcher mittels einer Magnetkupplung mit dem Zylinder verbunden ist.

Die Messeinrichtung kann auf einer Halterung bewegbar angeordnet sein. Dies ermöglicht die Bestimmung der Dicke bzw. des Verschleißes des Sputtertargets an mehreren, entlang der Bewegungsrichtung liegenden Punkten. Auf diese Weise kann festgestellt werden, ob das Sputtertarget gleichmäßig abgetragen wird. Dadurch kann vermieden werden, dass an einer einzelnen Stelle der Oberfläche des Sputtertargets das darunterliegende Material der Positioniereinrichtung abgetragen wird, obgleich das Sputtertarget an anderen Stellen noch eine ausreichende Dicke aufweist. In einigen Ausführungsformen der Erfindung kann durch zwei orthogonale Bewegungsrichtungen zwischen Target und Messeinrichtung eine dreidimensionale Vermessung der Oberfläche des Sputtertargets vorgesehen sein. In einigen Ausführungsformen der Erfindung kann die Messeinrichtung einen Liniendetektor für reflektierte Strahlung aufweisen, um durch eine relative Bewegung in zwischen Target und Messeinrichtung in einer Richtung eine dreidimensionale Vermessung der Oberfläche des Sputtertargets vorzunehmen. In einigen Ausführungsformen der Erfindung kann die Messeinrichtung einen Flächendetektor für reflektierte Strahlung aufweisen, um auch ohne Bewegung zwischen Target und Messeinrichtung eine dreidimensionale Vermessung der Oberfläche des Sputtertargets vorzunehmen.

In einigen Ausführungsformen der Erfindung kann die Vorrichtung zur Beschichtung eines Substrates weiterhin eine Regeleinrichtung enthalten, mittels welcher die Abtragrate des Sputtertargets auf einen vorgebbaren Sollwert geregelt wird und welcher ein den Zustand des Sputtertargets charakterisierender Messwert aus der Einrichtung zur Bestimmung des Abtrages des Sputtertargets zuführbar ist. Die Regeleinrichtung kann in einigen Ausführungsformen den Abstand der Oberfläche des Sputtertargets zur Oberfläche des Substrates und/oder den Abstand der Oberfläche des Sputtertargets zum Magnetron als Stellgröße beeinflussen. Auf diese Weise kann aus der fortlaufenden Überwachung der Dicke des Sputtertargets die Abtragrate ermittelt und mit großer Genauigkeit auf einen vorgebbaren Sollwert geregelt werden. In dieser Ausführungsform können auf dem Substrat besonders gleichmäßige Schichtdicken abgeschieden werden.

In einigen Ausführungsformen kann die Messeinrichtung dazu eingerichtet sein, den Abstand zwischen zumindest einem vorgebbaren Punkt außerhalb der Vakuumkammer und einer Mehrzahl vorgebbarer Punkte auf der Oberfläche des Sputtertargets zu bestimmen. Dies kann den Einsatz eines Linien- oder Zeilensensors in der Messeinrichtung umfassen. Hierdurch kann die Schichtdicke des Sputtertargets in einem größeren Flächenbereich bestimmt werden. Sofern das Sputtertarget an der so ausgestatteten Messeinrichtung vorbeibewegt wird, kann die Schichtdicke an der gesamten Oberfläche in nur einem Arbeitsgang vermessen werden. Dies erlaubt auch die Erkennung eines ungleichmäßigen Abtrags des Sputtertargets und einer Rillenbildung auf der Oberfläche des Sputtertargets, indem die Lage und die Extrempunkte aus den Messwerten bestimmt werden.

Nachfolgend soll die Erfindung anhand von Figuren ohne Beschränkung des allgemeinen Erfindungsgedankens näher erläutert werden. Dabei zeigen:

Figur 1      den Grundriss einer Vorrichtung zum Beschichten eines Substrates im Querschnitt;

Figur 2      den Aufriss einer Vorrichtung zum Beschichten eines Substrates im Querschnitt;

Figur 3      das Prinzip der Feinkorrektur der Messdaten;

Figur 4      die von der Messeinrichtung aufgenommenen Rohdaten nach einer Ausführungsform der Erfindung;

Figur 5      einen Ausschnitt aus den Rohdaten nach Figur 4; und

Figur 6      die Daten nach der erfindungsgemäß vorgeschlagenen Korrektur.

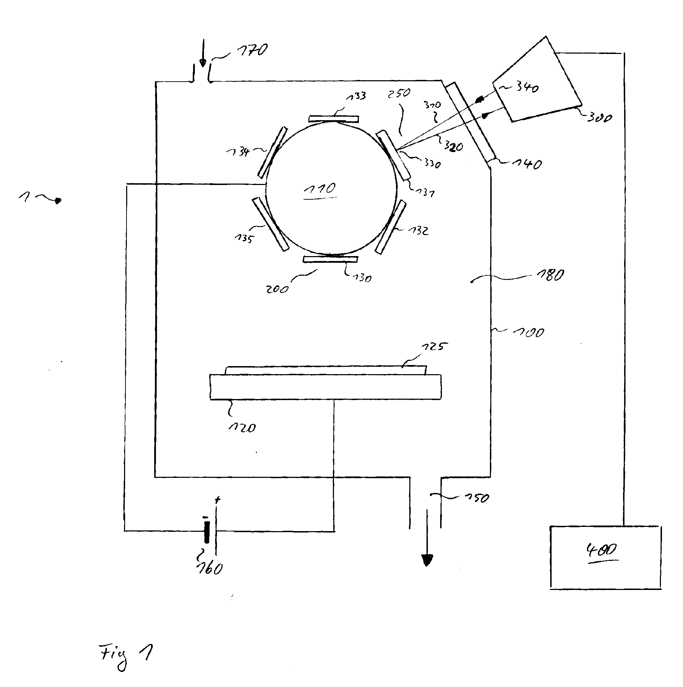

Figur 1 zeigt den Grundriss einer Vorrichtung 1 zum Beschichten eines Substrates. Die Vorrichtung 1 ist von einer Vakuumkammer 100 umgeben. Die Vakuumkammer 100 kann beispielsweise aus einem Metall oder einer Legierung hergestellt sein. In einigen Ausführungsformen kann die Vakuum-kammer aus einer Aluminiumlegierung oder einem Edelstahl hergestellt sein.

Die Vakuumkammer 100 weist einen Anschlussflansch 150 auf, über welchen die Vakuumkammer 100 mit einer nicht dargestellten Vakuumpumpe verbunden ist. Mittels der Vakuumpumpe kann in der Vakuumkammer in einigen Ausführungsformen ein Vakuum von weniger als $1\times10^5$ mbar, weniger als $1\times10^{-6}$ mbar oder weniger als $1\times10^{-6}$ mbar erzeugt werden.

Weiterhin weist die Vakuumkammer 100 zumindest eine Gaszuführung 170 auf. Über die Gaszuführung 170 kann ein Sputtergas in die Vakuumkammer eingelassen werden, beispielsweise Argon, Stickstoff oder Sauerstoff. Während dem Betrieb der Sputteranlage kann über die Gaszuführung 170 der Druck im Inneren der Vakuumkammer auf etwa $1\times10^{-2}$ mbar bis etwa 10 mbar, in einigen Ausführungsformen auf etwa $5\times10^{-2}$ mbar bis etwa 1 mbar geregelt werden.

Das zu beschichtende Substrat 125 ist auf einem Substrathalter 120 angeordnet. Der Substrathalter 120 kann dazu eingerichtet sein, zumindest ein Substrat 125 aufzunehmen. Der Substrathalter 120 kann eine Heizung oder eine Kühlung aufweisen, mit welcher das Substrat 125 auf eine vorgebbare Temperatur gebracht werden kann. Das Substrat 125 kann ein Halbleitermaterial, ein Werkzeug oder ein Architekturglas sein. Dementsprechend kann die auf dem Substrat 125 abzuscheidende Beschichtung eine Verschleißschutzschicht, eine Metallschicht, eine Wärmedämmschicht, eine Gleitschicht oder eine ähnliche Funktionsbeschichtung sein.

Die auf dem Substrat 125 abzuscheidende Beschichtung enthält zumindest ein Element, welches aus zumindest einem der Sputtertargets 130, 131, 132, 133, 134 und 135 abgeschieden wird. Daneben kann die abzuscheidende Beschichtung weitere Elemente enthalten, welche aus der Gasphase zugeführt werden, beispielsweise als Reaktivgas oder als unvermeidbare Verunreinigung aus dem Restgas. Die Sputtertargets 130, 131, 132, 133, 134 und 135 können eine identische oder eine verschiedene chemische Zusammensetzung aufweisen.

Die Sputtertargets 130 bis 135 sind auf einer Positioniereinrichtung 110 angeordnet. In der dargestellten Ausführungsform weist die Positioniereinrichtung 110 die Form eines rotierbaren Zylinders auf. Auf diese Weise kann jeweils ein Sputtertarget der in Figur 1 dargestellten sechs Sputtertargets 130 bis 135 in eine Betriebsposition 200 gebracht werden. In der Betriebsposition 200 steht das ausgewählte Sputtertargets, in der Figur 1 das Target 130, dem zu beschichteten Substrat 125 in etwa gegenüber. In anderen Ausführungsformen der Erfindung kann die Anzahl der Sputtertargets größer oder kleiner sein als sechs. Die Erfindung lehrt nicht das Einhalten einer bestimmten Anzahl als Lösungsprinzip.

Bei Betrieb der Beschichtungsanlage wird mittels einer Spannungsquelle 160 zwischen dem Substrathalter 120 und dem Sputtertarget 130 in der Betriebsposition 200 eine Potentialdifferenz angelegt. Die Potentialdifferenz kann als Gleichspannung zeitlich konstant oder als Wechselspannung zeitlich variabel sein. Die Potentialdifferenz kann dazu führen, dass sich zwischen der Oberfläche des zu beschichtenden Substrates 125 und der Oberfläche des in der Betriebsposition 200 befindlichen Sputtertargets 130 ein Plasma ausbildet. Aus dem Plasma können Ionen des über den Anschlussflansch 170 zugeführten Sputtergases auf die Oberfläche des Sputtertargets 130 beschleunigt werden. Das Material des Sputtertargets 130 wird dadurch abgetragen, wobei die aus dem Sputtertarget gelösten Atome zumindest teilweise auf dem Substrat 125 die gewünschte Beschichtung bilden. Die Erfindung ist jedoch nicht auf das dargestellte Ausführungsbeispiel beschränkt. In anderen Ausführungsformen der Erfindung kann das Plasma auch mittels einer elektromagnetischen Strahlung erzeugt werden, beispielsweise einer Mikrowellenstrahlung. In einigen Ausführungsformen der Erfindung kann zumindest eine Magnetfelderzeugungseinrichtung vorgesehen sein, um das Plasma auf einen vorgebbaren Raumbereich zwischen dem Sputtertarget 130 und dem zu beschichtenden Substrat 125 zu beschränken und/oder die Energiedichte im Plasma zu erhöhen.

Nachdem das Sputtertarget 130 zumindest auf einer Teilfläche vollständig zerstäubt wurde, ist die Positioniereinrichtung 110 und/oder eine unter dem Target angeordnete optionale Trägerplatte dem Angriff durch das Plasma ausgesetzt. Dies führt dazu, dass die auf dem Substrat 125 abgeschiedene Beschichtung mit dem Material dieser Bauteile verunreinigt wird. Sofern im Volumen der Positioniereinrichtung 110 und/oder der Trägerplatte Kühlkanäle angeordnet sind, kann das in den Kühlkanälen zirkulierende Kühlmittel, beispielsweise Wasser oder Druckluft, in den Innenraum 180 der Vakuumkammer 100 austreten. Um die genannten Nachteile zu verhindern, ist erfindungsgemäß vorgesehen, das Target 130 aus der Betriebsposition 200 durch Rotation der Positioniereinrichtung 110 in die Messposition 250 zu bringen. In Figur 1 ist das Sputtertarget 130 in der Messposition 250 dargestellt. Selbstverständlich können jedoch durch Rotation der Positioniereinrichtung 110 sämtliche Sputtertargets 130 bis 135 in die Messposition 250 gebracht werden, entweder zyklisch oder ereignisgesteuert, beispielsweise wenn der Benutzer der Vorrichtung 1 den Verschleiß des Sputtertargets 130 bestimmen möchte.

In der Messposition 250 ist die Oberfläche des Sputtertargets 131 durch ein Fenster 140 einsehbar. Das Fenster 140 ist aus einem Material, welches für die von der Messeinrichtung 300 ausgesandte elektromagnetische Strahlung 310 transparent ist. Eine Transparenz soll stets dann angenommen werden, wenn zumindest ein Bruchteil der elektromagnetischen Strahlung das Fenster durchdringen und auf die Oberfläche des Sputtertargets 131 auftreffen kann. Beispielsweise kann das Fenster 140 Glas oder Quarz oder Beryllium enthalten oder daraus bestehen.

Um die verbleibende Dicke des Sputtertargets 131 festzustellen, ist vorgesehen, mittels der Messeinrichtung 300 den Abstand zwischen zumindest einem vorgebbaren Punkt 340 außerhalb der Vakuumkammer und zumindest einem vorgebbaren Punkt 330 auf der Oberfläche des Sputtertargets 131 zu bestimmen. Beispielsweise kann der zumindest eine vorgebbare Punkt 340 durch die Position einer Austrittslinse oder eines Sensors oder eines Umlenkspiegels oder eines anderen Bauteils der Messeinrichtung 300 definiert sein. In anderen Ausführungsformen kann der vorgebbare Punkt 340 durch die Position eines den Messstrahl 310 erzeugenden Lasers definiert sein.

Der aus der Messeinrichtung 300 austretende Messstrahl 310 wird von der Oberfläche des Sputtertargets 131 im Punkt 330 zurückgeworfen. Der zurückgeworfene Lichtstrahl 320 kann die Vakuumkammer durch das Fenster 140 verlassen und mit der Messeinrichtung 300 nachgewiesen werden. Der Abstand zwischen den Punkten 340 und 330 kann dann aus der optischen Messung bestimmt werden, beispielsweise durch die Phasenverschiebung zwischen dem Messstrahl 310 und dem zurückgeworfenen Strahl 320, die Laufzeit des Lichtes oder durch Triangulation. In einigen Ausführungsformen der Erfindung kann die Messeinrichtung 300 einen örtlich auflösenden Sensor enthalten, um auf diese Weise die Position einer Mehrzahl von Punkten 330 auf der Oberfläche des Sputtertargets 131 zu bestimmen. Somit kann nicht nur ein einzelner Punkt 330, sondern eine Mehrzahl von Punkten 330 der Oberfläche des Sputtertargets 131 vermessen werden. Die Mehrzahl von Punkten 330 kann auf einer Linie angeordnet sein oder flächig über die Oberfläche des Sputtertargets verteilt sein.

Bei zunehmendem Verschleiß des Sputtertargets 131 wandert der Punkt 330 auf der Oberfläche des Sputtertargets 131 in Richtung der Positioniereinrichtung 110. Auf diese Weise wird der Abstand zwischen den Funken 340 und 330 größer. Die Vergrößerung des Abstandes entspricht gleichzeitig der Abnahme der Targetdicke des Sputtertargets 131. Sofern das Sputtertarget 131 mittels der Positioniereinrichtung 110 vor dem Fenster 140 rotiert wird, kann die gesamte in Figur 1 sichtbare Breite der Oberfläche des Targets 131 vermessen werden. Auf diese Weise kann auch ein ungleichmäßiger Abtrag des Sputtertargets 131 erkannt werden.

Die von der Messeinrichtung 300 erzeugten Messwerte können mittels einer Auswerteeinrichtung 400 weiterverarbeitet werden. Die Auswerteeinrichtung 400 kann beispielsweise einen Parallaxenversatz und/oder eine geometrische Verzerrung korrigieren. Eine solche geometrische Verzerrung kann sich beispielsweise aus der Rotation der Positioniereinrichtung 110 ergeben. Auf diese Weise wird eine ebene Oberfläche eines Sputtertargets 131 in eine Parabel abgebildet. Die Auswerteeinrichtung 400 kann dazu vorgesehen sein, die erhaltenen Messwerte zu visualisieren oder zu speichern. In anderen Ausführungsformen der Erfindung kann die Auswerteeinrichtung 400 ein Steuer- und/oder Regelsignal erzeugen, welches den im Innenraum 180 der Vakuumkammer 100 ablaufenden Beschichtungsprozess beeinflusst. Beispielsweise kann auf diese Weise ein ungleichmäßiger Abtrag des Sputtertargets 131 mit Rillenbildung erkannt oder eine gewünschte Beschichtungsrate erhalten werden.

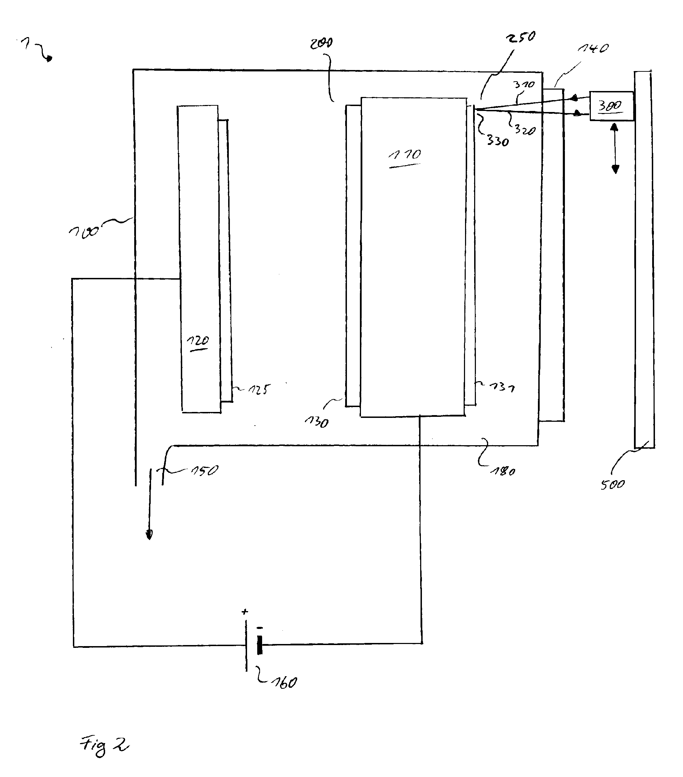

Figur 2 zeigt die Vorrichtung 1 gemäß Figur 1 im Aufriss. Dargestellt ist wiederum die Vakuumkammer 100 mit dem darin angeordneten Substrathalter 120 und einem darauf angeordneten zu beschichtenden Substrat 125. Dem Substrat 125 gegenüberliegend ist ein Sputtertarget 130 angeordnet, welches sich in der Betriebsposition 200 befindet. Bei Betrieb der Vorrichtung 1 wird das Sputtertarget 130 in der Betriebsposition 200 abgetragen, wie vorstehend in Zusammenhang mit Figur 1 erläutert.

Weiterhin ist in Figur 2 ein Sputtertarget 131 dargestellt, welches sich in der Messposition 250 befindet. In der Messposition 250 steht das Sputtertarget 131 dem Fenster 140 gegenüber. Das dargestellte Fenster 140 weist eine längliche Form auf, welche in etwa der Längserstreckung des Sputtertargets 131 entspricht. Auf diese Weise kann die gesamte Oberfläche des Sputtertargets 131 durch das Fenster 140 beobachtet werden.

Figur 2 zeigt weiterhin die Messeinrichtung 300, welche einen Messstrahl 310 auf die Oberfläche des Sputtertargets 131 aussendet. Der Messstrahl 310 wird im Punkt 330 auf der Oberfläche des Sputtertargets 131 reflektiert und als Lichtstrahl 320 in die Messeinrichtung 300 zurückgeworfen. Auf diese Weise kann der Verschleiß des Sputtertargets 131 im Punkt 330 bestimmt werden.

Um einen weiteren Messpunkt 330 an einer anderen Stelle der Oberfläche des Sputtertargets 131 aufzunehmen, ist die Messeinrichtung 300 auf einem Halter 500 beweglich gelagert. Die Messeinrichtung 300 kann somit entlang der Längserstreckung des Sputtertargets 131 bewegt werden, um auf diese Weise eine Mehrzahl von Messwerten aufzunehmen. Sofern zusätzlich die Positioniereinrichtung 110 gedreht wird, wie im Zusammenhang mit Figur 1 erläutert, ist die gesamte Oberfläche des Sputtertargets 131 für die Messeinrichtung 300 zugänglich. Auf diese Weise kann die Targetdicke des Sputtertargets 131 vollflächig vermessen werden.

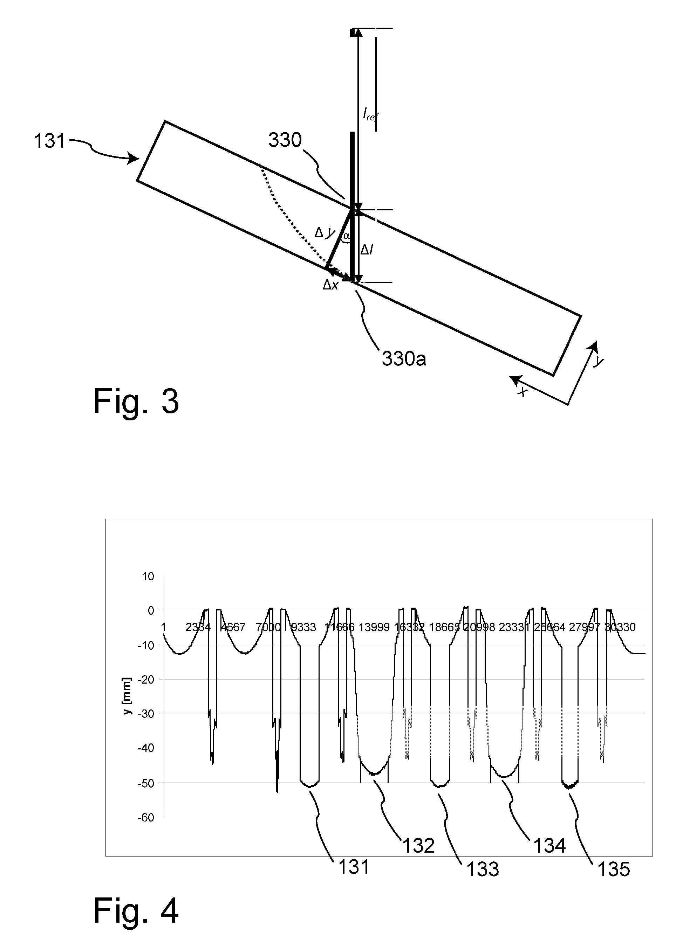

Figur 3 zeigt das Prinzip der Feinkorrektur der Messdaten, welche an einem rechteckigen Target 131 erhalten wurden, welches auf einer Positioniereinrichtung 110 angeordnet ist. Dabei ist die ursprüngliche Oberfläche eines neuen Targets als durchgezogene Linie und ein beispielhafter, sich im Betrieb durch den Abtrag des Targets ergebender Oberflächenverlauf gestrichelt dargestellt.

Die Positioniereinrichtung 110 enthält einen Zylinder, welcher um seine Längsachse drehbar gelagert ist. Wie bereits anhand von Figur 1 erläutert, ist seitlich neben dem Zylinder ein Fenster 140 angeordnet, durch das sich die Oberfläche des Targets 131 beobachten lässt, welches sich gerade vor dem Fenster 140 befindet. Die Positioniereinrichtung 110 erlaubt es, verschiedene Targets in die Messposition vor dem Fenster zu bewegen. Während dieser Bewegung kann die ganze Breite des Targets 131 vor die Messeinrichtung 300 bewegt werden, so dass während der Drehung der Positioniereinrichtung 110 der Querschnitt bzw. ein Profil entlang einer durch die Bewegungsrichtung definierten Schnittebene erstellt werden kann.

Da eine plane Oberfläche des Targets 131 nicht der Oberfläche des Zylinders folgt, kann der exakte Abstand nur für einen auf der Schnittlinie zwischen Target und Zylinder liegenden Messpunkt 330 direkt vermessen werden. Mit zunehmendem Abstand des Messpunktes von der Schnittlinie wird der Abstand zwischen Sensor und Targetoberfläche immer geringer, wodurch sich eine parabolische Verzerrung der Topographie in y-Richtung sowie eine Stauchung in x-Richtung ergibt. Diese Verzerrungen können mittels der vorgeschlagenen Auswerteeinrichtung 400 korrigiert werden, um die gewünschten, realen Oberflächeninformationen zu erhalten.

Da sich durch den Abtrag des Targets 131 der Abstand zwischen dem gemessenem Punkt 330a und der Messeinrichtung 300 um den Betrag $\Delta l$ vergrößert, kommt es bei schrägem Einfall des Laserlichts unter einem Blickwinkel $\alpha$ zur Flächennormalen zu einer Verschiebung $\Delta x$ des Messpunktes auf der Oberfläche. Diese Verschiebung kann in einigen Ausführungsformen der Erfindung ebenfalls korrigiert werden. Dabei errechnen sich die Verschiebung $\Delta x$ und der reale Abtrag $\Delta y$ des Targets in Abhängigkeit des Einfallswinkels $\alpha$ aus dem gemessenen Abtrag $\Delta l$ des Targets nach:

$$\Delta y = \Delta l \cdot \cos \alpha$$

$$\Delta x = \Delta l \cdot \sin \alpha$$

Der gemessene Abtrag $\Delta l$ des Targets nach einer vorgebbaren Betriebszeit ergibt sich aus der Differenz des nach einer vorgebbaren Betriebszeit gemessenen Abstandes $l_{meas}$ und dem zu Beginn des Beschichtungsprozesses gemessenen Abstand $l_{ref}$. Die erfindungsgemäße Korrektur der parabolischen Verzerrung basiert somit auf einem Vergleich der aktuellen Messdaten mit den Messdaten eines neuen, unverbrauchten Targets gleichen Typs.

Das Korrekturverfahren kann in einigen Ausführungsformen der Erfindung mehrstufig erfolgen. Im ersten Schritt werden die Referenz-Messdaten des neuen Targets $I_{ref}$ von den aktuellen Messdaten $I_{meas}$ subtrahiert, um die Messdaten in y-Richtung grob zu korrigieren und die Parabel in die Ebene zu projizieren. Anschließend erfolgt im zweiten Verfahrensschritt eine grobe Korrektur in x-Richtung, basierend auf einer berechneten Korrekturfunktion, welche an einem planaren, d.h. neuen Target ermittelt wurde. Die Korrekturfunktion kann dabei aus den geometrischen Eigenschaften der Vorrichtung 1 zum Beschichten eines Substrates und des Targets 131 bzw. der Positioniereinrichtung 110 bestimmt werden. Bei dieser Korrektur werden, basierend auf dem Radius des Zylinders und der Drehgeschwindigkeit in jedem Messpunkt sowie der Messfrequenz die x-Abstände zwischen den einzelnen Datenpunkten bestimmt und angepasst.

Durch den Abtrag des Targets und den Blickwinkel $\alpha$ ergeben sich zusätzliche Verschiebungen, einmal in y-Richtung ($\Delta y$) und daraus sowie aus dem schrägen Einfall des Laserlichts resultierend eine weitere Verzerrung in x-Richtung ($\Delta x$). Diese zusätzlichen Verzerrungen können im dritten Verfahrensschritt behoben werden. Aus der vorhergehenden Korrektur ist die x-Lage des Punktes auf einem neuen Target sowie $\Delta l$ bekannt. Unter Zuhilfenahme des Blickwinkels $\alpha$ können so $\Delta x$ und $\Delta y$ berechnet werden.

Nachfolgend soll ein Ausführungsbeispiel des erfindungsgemäßen Messverfahrens angegeben werden. Dabei zeigt Figur 4 die von der Messeinrichtung aufgenommenen Rohdaten nach einer Ausführungsform der Erfindung. Im dargestellten Beispiel sind fünf Targets 131, 132, 133, 134 und 135 auf der Mantelfläche einer zylindrischen Positioniereinrichtung 110 angeordnet. Bei einer vollständigen Drehung der Positioniereinrichtung 110 wird jedes Target einmal in den Erfassungsbereich der Messeinrichtung 330 gebracht, so dass die in Figur 4 dargestellten Rohdaten aufgenommen werden können. Dabei zeigt die Ordinate den Abstand zwischen einem vorgebbaren, ortsfesten Punkt, der beispielsweise durch die Position der Messeinrichtung 330 definiert werden kann. Die Abszisse zeigt die fortlaufende Nummer der Datenpunkte, welche über die Winkelgeschwindigkeit und die Messfrequenz in eine Koordinate auf der Mantelfläche des Zylinders bzw. eine x-Koordinate auf dem Target umgerechnet werden kann.

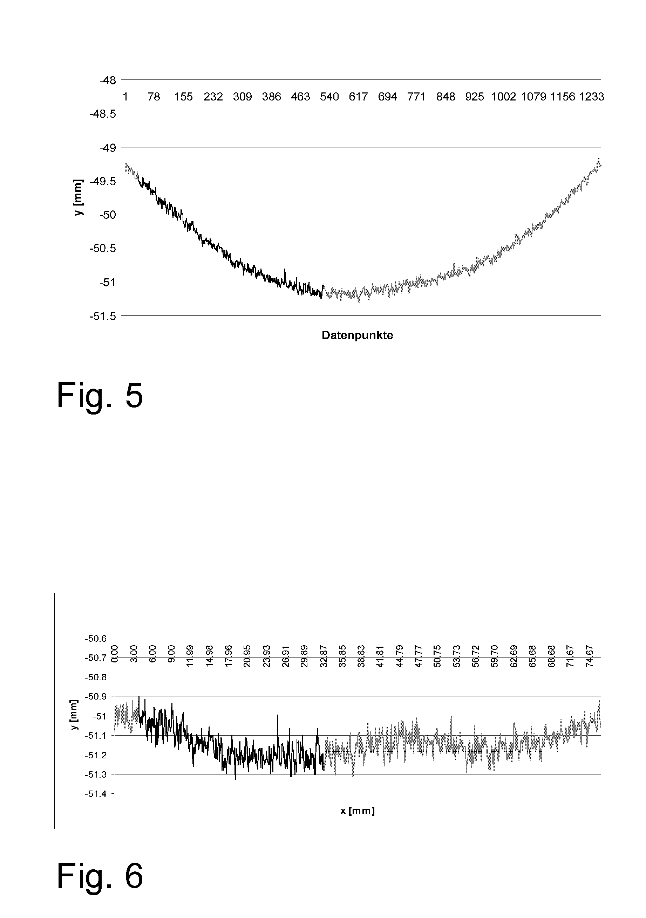

Figur 5 zeigt einen vergrößerten Ausschnitt aus den Rohdaten nach Figur 4. Der in Figur 5 dargestellte Bereich entspricht dabei den Messwerten, welche an einem einzelnen der insgesamt fünf Sputter-Targets aufgenommen wurden. Die dargestellten Messwerte wurden dabei an einem Target aufgenommen, welches bereits in einem Beschichtungsprozess verwendet wurde und daher einen Abtrag bzw. Verschleiß aufweist. Aus Figur 5 ist ersichtlich, dass dieser Abtrag durch die geometrischen Verzerrungen der Messeinrichtung überlagert und daher für den Benutzer der Sputteranlage 1 nicht ermittelbar ist.

Figur 6 zeigt die Daten gemäß Figur 5 nach der Durchführung des erfindungsgemäß vorgeschlagenen Korrekturverfahrens. Aus Figur 6 ist erkennbar, dass die Targetoberfläche zwei Rinnen bzw. Riefen aufweist, welche eine Tiefe von etwa 0,2 - 0,3 mm aufweisen. Der Abtrag des Targetmaterials kann somit mit dem Erfindungsgemäßen Verfahren mit hoher Genauigkeit bestimmt werden, ohne den Betrieb der Vorrichtung 1 zum Beschichten eines Substrates zu unterbrechen.

Die vorstehende Beschreibung ist nicht als beschränkend, sondern als erläuternd anzusehen. Die Beschreibung und die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche oder die Beschreibung "erste" und "zweite" Merkmale definieren, so dient diese Bezeichnung der Unterscheidung zweier gleichartiger Merkmale, ohne eine Rangfolge festzulegen.

**Patentansprüche**

1. Vorrichtung (1) zum Beschichten eines Substrates (125), umfassend eine Vakuumkammer (100), deren Innenraum (180) zur Aufnahme des zu beschichtenden Substrates (125) und zumindest eines Sputtertargets (130) vorgesehen ist, welches dazu vorgesehen ist, bei Betrieb der Vorrichtung (1) durch Teilchenbeschuss abgetragen zu werden, wobei die Vorrichtung (1) weiterhin eine Einrichtung (300) zur Bestimmung des Abtrages des Sputtertargets (130) enthält, wobei in der Wandung der Vakuumkammer (100) zumindest ein Fenster (140) angeordnet ist und die Einrichtung zur Bestimmung des Abtrages des Sputtertargets eine Messeinrichtung (300) zur optischen Messung des Abstandes zwischen zumindest einem vorgebbaren Punkt (340) außerhalb der Vakuumkammer und zumindest einem vorgebbaren Punkt (330) auf der Oberfläche des Sputtertargets (131) aufweist **dadurch gekennzeichnet, dass** die Messeinrichtung (300) weiterhin eine Auswerteeinrichtung (400) enthält, mittels welcher ein Parallaxenversatz und/oder eine geometrische Verzerrung korrigierbar ist.

2. Vorrichtung nach Anspruch 1, **dadurch gekennzeichnet, dass** diese eine Positioniereinrichtung (110) enthält, mit welcher das Sputtertarget (130, 131, 132, 133, 134, 135) von einer Betriebsposition (200) in eine Messposition (250) bewegbar ist.

3. Vorrichtung nach Anspruch 2, **dadurch gekennzeichnet, dass** die Positioniereinrichtung (110) einen Zylinder enthält, an dessen Mantelfläche zumindest ein Sputtertarget (130, 131, 132, 133, 134, 135) angeordnet ist.

4. Vorrichtung nach einem der Ansprüche 1 bis 3, **dadurch gekennzeichnet, dass** die Messeinrichtung (300) eine Einrichtung zur Lasertriangulation und/oder ein Interferometer enthält

5. Vorrichtung nach einem der Ansprüche 1 bis 4, **dadurch gekennzeichnet, dass** die Messeinrichtung (300) auf einer Halterung (500) bewegbar angeordnet ist.

6. Vorrichtung nach einem der Ansprüche 1 bis 5, weiterhin enthaltend eine Regeleinrichtung zur Regelung der Abtragrate des Sputtertargets (130) auf einen vorgebbaren Sollwert, welcher ein den Zustand des Sputtertargets (130) charakterisierender Messwert aus der Einrichtung (300) zur Bestimmung des Abtrages des Sputtertargets zuführbar ist.

7. Vorrichtung nach einem der Ansprüche 1 bis 6, **dadurch gekennzeichnet, dass** die Messeinrichtung (300) dazu eingerichtet ist, den Abstand zwischen zumindest einem vorgebbaren Punkt (340) außerhalb der Vakuumkammer und einer Mehrzahl vorgebbarer Punkte (330) auf der Oberfläche des Sputtertargets (131) zu bestimmen.

8. Verfahren zum Beschichten eines Substrates, bei welchem das Substrat (125) und zumindest ein Sputtertarget (130) in den Innenraum einer Vakuumkammer (100) eingebracht wird und das Sputtertarget (130) durch Teilchenbeschuss abgetragen und dessen Abtrag bestimmt wird, wobei durch ein in der Wandung der Vakuumkammer (100) angeordnetes Fenster (140) der Abstand zwischen zumindest einem vorgebbaren Punkt (340) außerhalb der Vakuumkammer (100) und zumindest einem vorgebbaren Punkt (330) auf der Oberfläche des Sputtertargets (131) optisch gemessen wird **dadurch gekennzeichnet, dass**
die gemessenen Abstände einer Auswerteeinrichtung zugeführt werden, welche zumindest einen Parallaxenversatz und/oder eine optische Verzerrung korrigiert.

9. Verfahren nach Anspruch 8, **dadurch gekennzeichnet, dass** der Beschichtungsprozess abgebrochen wird, wenn die Dicke des Sputtertargets (130) einen vorgebbaren Wert unterschreitet.

10. Verfahren nach Anspruch 8 oder 9, **dadurch gekennzeichnet, dass** ein Parallaxenversatz und/oder eine optische Verzerrung korrigiert wird, indem in einem ersten Schritt die Referenz-Messdaten $I_{ref}$ eines neuen Targets (131) von den aktuellen Messdaten $I_{meas}$ subtrahiert werden.

11. Verfahren nach einem der Ansprüche 8 bis 10, **dadurch gekennzeichnet, dass** ein Parallaxenversatz und/oder eine optische Verzerrung korrigiert wird, indem in einem zweiten Verfahrensschritt eine Korrektur in x-Richtung erfolgt, welche auf einer berechneten Korrekturfunktion basiert.

12. Verfahren nach Anspruch 11, **dadurch gekennzeichnet, dass** die Korrekturfunktion an einem planaren Target ermittelt wird und geometrische Eigenschaften der Vorrichtung (1) zum Beschichten eines Substrates (125) und des Targets (131) repräsentiert.

13. Verfahren nach einem der Ansprüche 8 bis 12, **dadurch gekennzeichnet, dass** eine Feinkorrektur der Messdaten aus dem Blickwinkel $\alpha$ zur Flächennormalen und dem gemessenen Abtrag $\Delta l$ des Targets nach folgender Gleichung erfolgt:

$$\Delta y = \Delta l \cdot \cos \alpha$$

$$\Delta x = \Delta l \cdot \sin \alpha$$

14. Computerprogramm zu Durchführung eines Verfahrens nach einem der Ansprüche 8 bis 13, wenn das Computerprogramm auf einem Computer ausgeführt wird.

15. Computerprogramm mit Programmcode, der auf einem maschinenlesbaren Träger gespeichert ist, zur Durchführung des Verfahrens nach einem der Ansprüche 8 bis 13, wenn das Computerprogramm auf einem Computer ausgeführt wird.

**Claims**

1. Apparatus (1) for coating a substrate (125), comprising a vacuum chamber (100), the interior (180) of which is provided for receiving the substrate (125) to be coated and at least one sputtering target (130), which is intended to be removed by particle bombardment when the apparatus (1) is operated, the apparatus (1) also containing a device (300) for determining the removal of the sputtering target (130), at least one window (140) being arranged in the wall of the vacuum chamber (100) and the device for determining the removal of the sputtering target having a measurement device (300) for the optical measurement of the distance between at least one predeterminable point (340) outside the vacuum chamber and at least one predeterminable point (330) on the surface of the sputtering target (131), **characterized in that**

the measurement device (300) also contains an assessment device (400), by means of which a parallel axis displacement and/or a geometric distortion can be corrected.

2. Apparatus according to claim 1, **characterized in that** it contains a positioning device (110), by means of which the sputtering target (130, 131, 132, 133, 134, 135) can be moved from an operating position (200) into a measurement position (250).

3. Apparatus according to claim 2, **characterized in that** the positioning device (110) contains a cylinder, on the lateral surface of which at least one sputtering target (130, 131, 132, 133, 134, 135) is arranged.

4. Apparatus according to any of claims 1 to 3, **characterized in that** the measurement device (300) contains a device for the laser triangulation and/or an interferometer.

5. Apparatus according to any of claims 1 to 4, **characterized in that** the measurement device (300) is movably arranged on a holder (500).

6. Apparatus according to any of claims 1 to 5, further containing a control device for controlling the removal rate of the sputtering target (130) on a predeterminable nominal value, which can be provided with a measured value from the device (300) that characterizes the state of the sputtering target (130) in order to determine the removal of the sputtering target.

7. Apparatus according to any of claims 1 to 6, **characterized in that** the measurement device (300) is adapted to determine the distance between at least one predeterminable point (340) outside the vacuum chamber and a plurality of predeterminable points (330) on the surface of the sputtering target (131).

8. Method for coating a substrate where the substrate (125) and at least one sputtering target (130) are introduced into the interior of a vacuum chamber (100) and the sputtering target (130) is removed by particle bombardment and the removal thereof is determined, wherein the distance between the at least one predeterminable point (340) outside the vacuum chamber (100) and at least one predeterminable point (330) on the surface of the sputtering target (131) is optically measured through a window arranged in the wall of the vacuum chamber (100), **characterized in that** the measured distances are supplied to an assessment device which corrects at least one parallel axis displacement and/or one optical distortion.

9. Method according to claim 8, **characterized in that** the coating process is discontinued when the thickness of the sputtering target (130) drops below a predeterminable value.

10. Method according to claim 8 or 9, **characterized in that** a parallel axis displacement and/or an optical distortion is corrected by subtracting the reference measured data $l_{ref}$ of a new target (131) from the current measured data $L_{mess}$ in a first step.

11. Method according to any of claims 8 to 10, **characterized in that** a parallel axis displacement and/or an optical distortion is corrected by carrying out a correction in the x-direction in a second method step, said correction being based on a calculated correction function.

12. Method according to claim 11, **characterized in that** the correction function is determined with a planar target and represents geometric properties of the apparatus (1) for coating a substrate (125) and the target (131).

13. Method according to any of claims 8 to 12, **characterized in that** a fine correction of the measured data is carried out from the viewing angle $\alpha$ in relation to the surface normal and the measured removal $\Delta 1$ of the target according to the following equation:

$$\Delta y = \Delta l \cdot \cos \alpha$$

$$\Delta x = \Delta l \cdot \sin \alpha$$

14. Computer program for carrying out a method according to any of claims 8 to 13, when the computer program is executed on a computer.

15. Computer program with program code, which is stored on a machine-readable carrier, for carrying out the method according to any of claims 8 to 13 when the computer program is executed on a computer.

**Revendications**

1. Dispositif (1) pour le revêtement d'un substrat (125), incluant une chambre à vide (100), dont le volume intérieur (180) est prévu pour recevoir le substrat (125) à revêtir et au moins une cible de pulvérisation (130), laquelle est prévue pour être érodée lors du fonctionnement du dispositif (1) par bombardement de particules, dans lequel le dispositif (1) contient en outre un moyen (300) pour déterminer l'érosion de la cible de pulvérisation (130), dans lequel au moins une fenêtre (140) est agencée dans la paroi de la chambre à vide (100) et le moyen pour déterminer l'érosion de la cible de pulvérisation (130) comprend un dispositif de mesure (300) pour la mesure optique de la distance entre au moins un point prédéterminé (340) à l'extérieur de la chambre à vide et au moins un point prédéterminé (330) sur la surface de la cible de pulvérisation (131),
**caractérisé en ce que**
le dispositif de mesure (300) contient en outre un dispositif d'évaluation (400) au moyen duquel un décalage de parallaxe et/ou une distorsion géométrique peut être corrigée.

**2.** Dispositif selon la revendication 1, **caractérisé en ce que** celui-ci contient un dispositif de positionnement (110) au moyen duquel la cible de pulvérisation (130, 131, 132, 133, 134, 135) est déplaçable depuis une position de service (200) jusque dans une position de mesure (250).

**3.** Dispositif selon la revendication 2, **caractérisé en ce que** le dispositif de positionnement (110) contient un cylindre, à la surface enveloppe duquel est agencée au moins une cible de pulvérisation (130, 131, 132, 133, 134, 135).

**4.** Dispositif selon l'une des revendications 1 à 3, **caractérisé en ce que** le dispositif de mesure (300) contient un système pour la triangulation laser et/ou un interféromètre.

**5.** Dispositif selon l'une des revendications 1 à 4, **caractérisé en ce que** le dispositif de mesure (300) est agencé déplaçable sur une monture (500).

**6.** Dispositif selon l'une des revendications 1 à 5, contenant en outre un dispositif de régulation pour la régulation de la vitesse d'érosion de la cible de pulvérisation (130) à une valeur de consigne prédéterminée, dispositif auquel peut être amenée une valeur de mesure, provenant du dispositif (300) pour la détermination de l'érosion de la cible de pulvérisation, qui caractérise l'état de la cible de pulvérisation (130).

**7.** Dispositif selon l'une des revendications 1 à 6, **caractérisé en ce que** le dispositif de mesure (300) est conçu pour déterminer la distance entre au moins un point prédéterminé (340) à l'extérieur de la chambre à vide et une pluralité de points prédéterminés (330) sur la surface de la cible de pulvérisation (131).

**8.** Procédé pour le revêtement d'un substrat, dans lequel le substrat (125) et au moins une cible de pulvérisation (130) sont introduits dans le volume intérieur d'une chambre à vide (100) et la cible de pulvérisation (130) est érodée par bombardement de particules, et son érosion est déterminée, dans lequel, à travers une fenêtre (140) agencée dans la paroi de la chambre à vide (100) on mesure par voie optique la distance entre au moins un point prédéterminé (340) à l'extérieur de la chambre à vide (100) et au moins un point prédéterminé (130) sur la surface de la cible de pulvérisation (131),
**caractérisé en ce que**
les distances mesurées sont amenées à un dispositif d'évaluation qui corrige au moins un décalage de parallaxe et/ou une distorsion optique.

**9.** Procédé selon la revendication 8, **caractérisé en ce que** le processus de revêtement est interrompu quand l'épaisseur de la cible de pulvérisation (130) passe au-dessous d'une valeur prédéterminée.

**10.** Procédé selon la revendication 8 ou 9, **caractérisé en ce que** l'on corrige un décalage de parallaxe et/ou une distorsion optique en soustrayant, dans une première étape, les données de mesure de référence $I_{ref}$ d'une nouvelle cible (131) depuis les données de mesures actuelles Imeas.

**11.** Procédé selon l'une des revendications 8 à 10, **caractérisé en ce que** l'on corrige un décalage de parallaxe et/ou une distorsion optique en procédant, dans une seconde étape de procédé, à une correction en direction x, qui est basée sur une fonction de correction calculée.

**12.** Procédé selon la revendication 11, **caractérisé en ce que** la fonction de correction est déterminée sur une cible plane et représente des propriétés géométriques du dispositif (1) pour le revêtement d'un substrat (125) et de la cible (131).

**13.** Procédé selon l'une des revendications 8 à 12, **caractérisé en ce que** l'on procède à une correction fine des données de mesure depuis l'angle d'observation $\alpha$ par rapport à la normale à la surface et à partir de l'érosion mesurée $\Delta l$ de la cible selon l'équation suivante :

$$\Delta y = \Delta l \cdot \cos\alpha$$

$$\Delta x = \Delta l \cdot \sin\alpha.$$

**14.** Programme d'ordinateur pour la mise en oeuvre d'un procédé selon l'une des revendications 8 à 13 lorsque le programme d'ordinateur est exécuté sur un ordinateur.

**15.** Programme d'ordinateur avec un code de programme qui est mémorisé sur un support lisible à la machine, pour la mise en oeuvre du procédé selon l'une des revendications 8 à 13 quand le programme d'ordinateur est exécuté sur un ordinateur.

Fig 1

Fig 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   DE 10234862 A1

**In der Beschreibung aufgeführte Nicht-Patentliteratur**

*   **ZHU X D et al.** Epitaxial growth of SrTiO3, on SrTiO3(001) using an oblique-incidence reflectance-difference technique. *PHYSICAL REVIEW B (CONDENSED MATTER) APS THROUGH AIP USA,* 15. Januar 1998, vol. 57 (4), ISSN 0163-1829, 2514-2519